# EUROPEAN PATENT APPLICATION

(11) **EP 4 700 060 A1**
(43) Date of publication of application: **25.02.2026**
(21) Application number: 25194275.1
(22) Date of filing: 06.08.2025
(51) Int. Cl.: C08G 59/40

(54) **HEAT-CURABLE RESIN COMPOSITION AND USES THEREOF**

(30) Priority: 20.08.2024 JP 2024138937
(71) Applicant: SHIN-ETSU CHEMICAL CO., LTD., Tokyo 100-0005 (JP)
(72) Inventor: MOCHIZUKI, Takanari, Annaka, 3790224 (JP); OSADA, Shoichi, Annaka, 3790224 (JP); HORIGOME, Hiroki, Annaka, 3790224 (JP)
(74) Representative: Angerhausen, Christoph

(57) **Abstract**

A heat-curable resin composition contains: (A) an aliphatic biscitraconimide compound represented by formula (1) defined as: 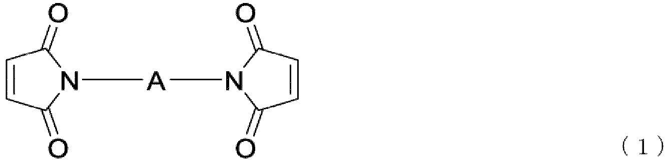 wherein, in the formula (1), A is a divalent aliphatic hydrocarbon group having 2 to 12 carbon atoms; and (B) an epoxy resin containing two or more epoxy groups in one molecule. The amount of the component (A) is in the range of 20 to 95% by mass based on the total amount of the aliphatic biscitraconimide compound (A) and the epoxy resin (B).

## Description

### BACKGROUND OF THE INVENTION

### Field of the invention

The present invention relates to a cured product of a heat-curable resin suitable for use as an encapsulant for power semiconductors, and to uses thereof.

### Background art

SiC power semiconductors have attracted much attention because they enable efficient power utilization and miniaturization of devices compared to Si power semiconductors in the related art. Particularly in recent years, there has been a trend toward higher power density in devices. It is known that the chip temperature reaches 200°C or higher during operation. Consequently, there is a strong demand for the development of encapsulant materials that exhibit excellent long-term heat resistance at a high temperature of 200°C and excellent tracking resistance, as indicated by a comparative tracking index (CTI).

Regarding long-term heat resistance at 200°C, JP-A-2015-193628 and JP-A-2019-064926 each report that a resin composition containing a maleimide-based resin exhibits excellent heat resistance, with a glass transition temperature (Tg) higher than 300°C and a 5% weight loss temperature (Td5) higher than 400°C. This is presumably due to the high crosslink density that is characteristic of the maleimide-based resin, in addition to the rigidity of the aromatic ring component in the structure of each resin.

With regard to tracking resistance, JP-A-2005-213299 and JP-A-2023-019588 each report that excellent tracking resistance can be achieved by introducing an alicyclic structure into an epoxy resin structure. This is presumably because the formation of carbonized conductive paths, which are the cause of tracking, is inhibited by reducing the proportion of aromatic rings in the structure.

### SUMMARY OF THE INVENTION

However, the resin compositions containing maleimide-based resins and having high heat resistance have poor tracking resistance, and the epoxy resin-containing resin compositions with tracking resistance have poor heat resistance.

Accordingly, it is an object of the present invention to provide a heat-curable resin composition that gives a cured product having high strength, long-term heat resistance, and tracking resistance, and an encapsulant for a semiconductor, the encapsulant being produced using the heat-curable resin composition and particularly useful for applications as an encapsulant for power semiconductors that require a high-strength resin, long-term heat resistance under high-temperature conditions, and a tracking resistance of 600 V or more.

The inventors have conducted intensive studies to achieve the above object and have found that the following heat-curable resin composition can achieve the above object, thereby completing the present invention. That is, the present invention provides the following heat-curable resin composition.
<1> A heat-curable resin composition, comprising:
   (A) an aliphatic biscitraconimide compound represented by formula (1) defined as 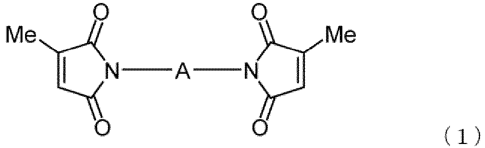 wherein, in the formula (1), A is a divalent aliphatic hydrocarbon group having 2 to 12 carbon atoms; and
   (B) an epoxy resin containing two or more epoxy groups in one molecule,
   wherein the aliphatic biscitraconimide compound (A) is contained therein in an amount of 20 to 95% by mass based on the total amount of the aliphatic biscitraconimide compound (A) and the epoxy resin (B).
<2> The heat-curable resin composition according to <1>, wherein, in the formula (1), A is a divalent chain aliphatic hydrocarbon group having 2 to 12 carbon atoms.
<3> The heat-curable resin composition according to <1> or <2>, further comprising (C) a curing accelerator.
<4> The heat-curable resin composition according to <3>, wherein the curing accelerator (C) contains one or more selected from imidazole-based curing accelerators, organophosphorus-based curing accelerators, and tertiary amine-based curing accelerators.
<5> An encapsulant for a semiconductor, comprising the heat-curable resin composition according to any one of <1> to <4>.
<6> The encapsulant for a semiconductor according to <5>, wherein the semiconductor is a power semiconductor.

### DETAILED DESCRIPTION OF THE INVENTION

### (A) Aliphatic Biscitraconimide Compound

The component (A) used in an embodiment of the present invention is an aliphatic biscitraconimide compound represented by formula (1) defined as 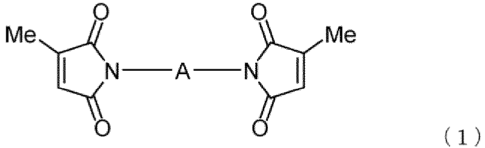 wherein, in the formula (1), A is a divalent aliphatic hydrocarbon group having 2 to 12, preferably 6 to 9, carbon atoms. The aliphatic hydrocarbon group represented by A may be any of linear, branched, and cyclic.

The aliphatic biscitraconimide compound of component (A) is not particularly limited in terms of its properties at room temperature (25°C ± 10°C) or its number-average molecular weight, but the number-average molecular weight is preferably 100 to 10,000, more preferably 100 to 5,000, and still more preferably 100 to 1,000.

In this specification, the number-average molecular weight refers to a number-average molecular weight calculated using polystyrene standards based on gel permeation chromatography (GPC) measurements conducted under the following measurement conditions.
GPC Measurement Conditions
Eluent: tetrahydrofuran (THF)
Flow rate: 0.35 mL/min
Detector: differential refractive index detector (RI)
Column: TSK Guardcolumn SuperH-L
   TSKgel SuperHZ4000 (4.6 mm I.D. × 15 cm × 1)
   TSKgel SuperHZ3000 (4.6 mm I.D. × 15 cm × 1)
   TSKgel SuperHZ2000 (4.6 mm I.D. × 15 cm × 2)
   (All manufactured by Tosoh Corporation)
Column temperature: 40°C
Sample injection volume: 5 µL (a THF solution with a concentration of 0.2% by mass)

The aliphatic biscitraconimide compound of component (A) may be used alone, or two or more types thereof may be used in combination.

The composition according to an embodiment of the present invention is characterized in that the amount of the component (A) is in the range of 20 to 95% by mass, preferably 50 to 95% by mass based on 100% by mass of the total of the components (A) and (B). When the proportion of the component (A) to the component (B) amounts to a value that satisfy this range, a cured product free of cracks is easily formed.

In the composition according to an embodiment of the present invention, the total amount of the components (A) and (B) is preferably in the range of 45 to 100% by mass, more preferably 50 to 99% by mass.

### (B) Epoxy Resin

The epoxy resin (B) is added for the purpose of promoting the reaction of the aliphatic biscitraconimide compound (A) and for the purpose of maintaining the shape of the cured product.

The epoxy resin contains two or more epoxy groups in one molecule, and such a known epoxy resin can be used.

Examples thereof include bisphenol-type epoxy resins, such as bisphenol A-type epoxy resins, bisphenol F-type epoxy resins, and bisphenol S-type epoxy resins; novolac-type epoxy resins, such as phenolic novolac-type epoxy resins, cresol novolac-type epoxy resins, bisphenol A novolac-type epoxy resins, and bisphenol F novolac-type epoxy resins; alicyclic epoxy resins, such as dicyclopentadiene-type epoxy resins and 3,4-epoxycyclohexenylmethyl-3',4'-epoxycyclohexenecarboxylate; polyfunctional phenolic epoxy resins, such as resorcinol-type epoxy resins and resorcinol novolac-type epoxy resins; diglycidyl ether compounds of polycyclic aromatic compounds, such as stilbene-type epoxy resins, triazine skeleton-containing epoxy resins, fluorene skeleton-containing epoxy resins, triphenol alkane-type epoxy resins, biphenyl-type epoxy resins, xylylene-type epoxy resins, biphenyl aralkyl-type epoxy resins, naphthalene-type epoxy resins, and anthracene; and phosphorus-containing epoxy resins obtained by introducing phosphorus compounds into these resins.

Among these, epoxy resins containing cyclic saturated hydrocarbon groups in their molecules are preferably used because of their superior tracking resistance.

These may be used alone or in combination of two or more.

The composition of the present invention contains the component (B) in an amount of 5 to 80% by mass, preferably 5 to 50% by mass, based on 100% by mass of the total of the components (A) and (B). When the proportion of the component (A) to the component (B) amounts to a value that satisfy this range, a cured product free of cracks is easily formed.

### (C) Curing Accelerator

The curing accelerator of component (C) is an optional component that is incorporated in order to accelerate the curing of the aliphatic biscitraconimide compound (A). Commonly known curing accelerators, such as imidazole-based curing accelerators, organophosphorus-based curing accelerators, and tertiary amine-based curing accelerators, can be used.

Examples of the organophosphorus-based curing accelerator include phosphines, such as triphenylphosphine, tributylphosphine, tri(p-methylphenyl)phosphine, and tri(nonylphenyl)phosphine; phosphine-borane complexes, such as triphenylphosphine-triphenylborane; phosphonium borate salts, such as tetraphenylphosphonium tetraphenylborate, tetraphenylphosphonium tetra-p-tolylborate, p-tolyltriphenylphosphonium tetra-p-tolylborate, and tri-tert-butylphosphonium tetraphenylborate; and bis(tetrabutylphosphonium) dihydrogen pyromellitate.

Examples of the tertiary amine-based curing accelerator include tertiary amine compounds, such as triethylamine, benzyldimethylamine, α-methylbenzyldimethylamine, and 1,8-diazabicyclo[5.4.0]undec-7-ene; and salts of tertiary amine compounds, such as 1,8-diazabicyclo[5.4.0]undec-7-ene.

Examples of the imidazole-based curing accelerator include 2-methylimidazole, 2-phenylimidazole, 2-ethyl-4-methylimidazole, and 2-phenyl-4-methylimidazole.

Component (C) may be used alone, or two or more types thereof may be used in combination.

To promote curing, the amount of curing accelerator (C) added is preferably 0.01 to 10 parts by mass, more preferably 1 to 5 parts by mass, based on 100 parts by mass of the total of component (A) and component (B).

### Other Additives

In addition to components (A) to (C) described above, other additives may be added to the heat-curable resin composition according to an embodiment of the present invention, if necessary, within the range that does not impair the object and effects of the present invention. Examples of such additives include inorganic fillers, flame retardants, ion-trapping agents, antioxidants, adhesion-imparting agents, stress-reducing agents, and colorants.

Such an inorganic filler is incorporated into the heat-curable resin composition for the purposes of improving resin strength and reducing thermal expansion. Examples of the inorganic filler include silicas, such as fused silica, crystalline silica, and cristobalite, alumina, silicon nitride, aluminum nitride, boron nitride, titanium oxide, glass fibers, and magnesium oxide. The average particle diameters and shapes of these inorganic fillers can be selected in accordance with applications.

To increase the bonding strength between the resin and the inorganic filler, it is preferable to use an inorganic filler that has been subjected, in advance, to surface treatment with a coupling agent, such as a silane coupling agent or a titanate coupling agent. Examples of the coupling agent include silane coupling agents, such as epoxysilanes, e.g., γ-glycidoxypropyltrimethoxysilane, γ-glycidoxypropylmethyldiethoxysilane, and β-(3,4-epoxycyclohexyl)ethyltrimethoxysilane; aminosilanes, e.g., N-β-(aminoethyl)-γ-aminopropyltrimethoxysilane, a reaction product of imidazole and γ-glycidoxypropyltrimethoxysilane, γ-aminopropyltriethoxysilane, and N-phenyl-γ-aminopropyltrimethoxysilane; and mercaptosilanes, e.g., γ-mercaptosilane and γ-episulfidoxypropyltrimethoxysilane. The amount of the coupling agent used in the surface treatment and a surface treatment method are not particularly limited.

The amount of the inorganic filler added is preferably 10 to 20,000 parts by mass, more preferably 30 to 10,000 parts by mass, based on 100 parts by mass of the total of component (A) and component (B).

The flame retardant is added for the purpose of imparting flame retardancy. The flame retardant is not particularly limited, and any known flame retardant can be used. Examples of the flame retardant that can be used include phosphazene compounds, silicone compounds, zinc molybdate-supported talc, zinc molybdate-supported zinc oxide, aluminum hydroxide, magnesium hydroxide, and molybdenum oxide.

The ion-trapping agent is added for the purpose of trapping ionic impurities contained in the resin composition to inhibit thermal degradation and degradation due to moisture absorption. The ion-trapping agent is not particularly limited, and any known agent can be used. For example, a hydrotalcite, a bismuth hydroxide compound, or a rare-earth oxide may be used.

The antioxidant is not particularly limited. Examples thereof include phenolic antioxidants, such as n-octadecyl 3-(3,5-di-tert-butyl-4-hydroxyphenyl)propionate, n-octadecyl 3-(3,5-di-tert-butyl-4-hydroxyphenyl)acetate, neododecyl 3-(3,5-di-tert-butyl-4-hydroxyphenyl)propionate, dodecyl β-(3,5-di-tert-butyl-4-hydroxyphenyl)propionate, ethyl α-(4-hydroxy-3,5-di-tert-butylphenyl)isobutyrate, octadecyl α-(4-hydroxy-3,5-di-tert-butylphenyl)isobutyrate, octadecyl α-(4-hydroxy-3,5-di-tert-butyl-4-hydroxyphenyl)propionate, 2-(n-octylthio)ethyl 3,5-di-tert-butyl-4-hydroxyphenylacetate, 2-(n-octadecylthio)ethyl 3,5-di-tert-butyl-4-hydroxyphenylacetate, 2-(n-octadecylthio)ethyl 3-(3,5-di-tert-butyl-4-hydroxyphenyl)propionate, 2-(2-stearoyloxyethylthio)ethyl 7-(3-methyl-5-tert-butyl-4-hydroxyphenyl)heptanoate, 2-hydroxyethyl 7-(3-methyl-5-tert-butyl-4-hydroxyphenyl)propionate, and pentaerythritol tetrakis[3-(3,5-di-tert-butyl-4-hydroxyphenyl)propionate]; sulfur antioxidants, such as dilauryl 3,3'-thiodipropionate, dimyristyl 3,3'-thiodipropionate, distearyl 3,3'-thiodipropionate, ditridecyl 3,3'-thiodipropionate, and pentaerythrityl tetrakis(3-laurylthiopropionate); and phosphorus-based antioxidants, such as tridecyl phosphite, triphenyl phosphite, tris(2,4-di-tert-butylphenyl) phosphite, 2-ethylhexyl diphenyl phosphite, diphenyl tridecyl phosphite, 2,2-methylenebis(4,6-di-tert-butylphenyl) octyl phosphite, distearyl pentaerythritol diphosphite, bis(2,6-di-tert-butyl-4-methylphenyl) pentaerythritol diphosphite, and 2-[[2,4,8,10-tetrakis(1,1-dimethylethyl)dibenzo[d,fl[1,3,2] dioxaphosphepin-6-yl]oxy]-N,N-bis[2-[[2,4,8,10-tetrakis(1,1-dimethylethyl)dibenzo[d,f][1,3,2]dioxaphosphepin-6-yl]oxy]ethyl]ethanamine.

The adhesion-imparting agent is not particularly limited as long as it is a known adhesion-imparting agent and exhibits the effects of the present invention. An adhesion-imparting agent may be contained as necessary in order to impart adhesiveness or tackiness (pressure-sensitive adhesion). Examples of the adhesion-imparting agent include urethane resins, phenolic resins, terpene resins, and silane coupling agents. Among these, silane coupling agents are preferred for imparting adhesiveness.

The silane coupling agent is not particularly limited. Examples thereof include silane coupling agents, such as n-propyltrimethoxysilane, n-propyltriethoxysilane, n-octyltrimethoxysilane, n-octyltriethoxysilane, phenyltrimethoxysilane, phenyltriethoxysilane, methyltrimethoxysilane, methyltriethoxysilane, 2-[methoxy(polyethyleneoxy)propyl]trimethoxysilane, methoxytri(ethyleneoxy)propyltrimethoxysilane, 3-glycidyloxypropyltrimethoxysilane, 3-aminopropyltrimethoxysilane, 3-mercaptopropyltrimethoxysilane, 3-(methacryloyloxy)propyltrimethoxysilane, 3-isocyanatopropyltriethoxysilane, and 3-isocyanatopropyltrimethoxysilane.

The amount of the other additives added varies in accordance with the purpose of the composition, but is usually 5% or less by mass of the entire composition excluding the inorganic filler.

### Method for Producing Composition

The heat-curable resin composition according to an embodiment of the present invention can be produced by the following method. For example, components (A) and (B) are mixed, stirred, dissolved, and/or dispersed, either simultaneously or separately, if necessary, while being subjected to a heat treatment, to provide a mixture of components (A) and (B). If necessary, curing accelerator (C) may be added to the mixture of components (A) and (B), and the mixture may be stirred and dissolved and/or dispersed to provide a mixture of components (A) to (C). Depending on the intended use, at least one of an inorganic filler, a flame retardant, a polymerization initiator, and an ion-trapping agent may be added to the mixture of components (A) to (C), and the resulting mixture may be mixed. A single type of each component may be used, or two or more types may be used in combination.

Any device may be used for mixing, stirring, and dispersing in the method for producing the composition. Specifically, for example, a mortar and pestle machine equipped with a stirring and heating device, a two-roll mill, a three-roll mill, a ball mill, a planetary mixer, or a grinder, such as a Supermasscolloider, can be used. These devices may also be used in appropriate combination.

### Applications

The heat-curable resin composition according to an embodiment of the present invention provides a cured product having excellent tracking resistance (CTI ≥ 600 V) and high heat resistance, and thus can be suitably used as an adhesive or an encapsulant for semiconductors.

When the heat-curable resin composition is used as an encapsulant for semiconductors, the components are preferably mixed together in a predetermined composition ratio as described above and sufficiently uniformly stirred with a mixer or the like. The mixture is preferably melt-mixed with a hot roll, a kneader, an extruder, or the like and then cooled to solidify the resulting product. The product is preferably pulverized to an appropriate size.

Examples of common molding methods using an encapsulant for semiconductors include a transfer molding method and a compression molding method. In the transfer molding method, a transfer molding machine is used. The method is performed at a molding pressure of 5 to 20 N/mm² and a molding temperature of 120°C to 190°C for a molding time of 30 to 500 seconds, preferably at a molding temperature of 150°C to 185°C for a molding time of 30 to 180 seconds. In the compression molding method, a compression molding machine is used. The method is performed at a molding temperature of 120°C to 190°C for a molding time of 30 to 600 seconds, preferably at a molding temperature of 130°C to 160°C for a molding time of 120 to 300 seconds. In either molding method, post curing may be performed at 150°C to 225°C for 0.5 to 20 hours.

### WORKING EXAMPLES

The present invention will be specifically described below with reference to Working Examples and Comparative examples, but the present invention is not limited to the following examples. In the following, the number-average molecular weight (Mn) was measured by gel permeation chromatography (GPC) under the following measurement conditions using polystyrene as a reference. In the following formulae, each Me represents a methyl group.
GPC Measurement Conditions
Eluent: tetrahydrofuran (THF)
Flow rate: 0.35 mL/min
Detector: differential refractive index detector (RI)
Column: TSK Guardcolumn SuperH-L
   TSKgel SuperHZ4000 (4.6 mm I.D. × 15 cm × 1)
   TSKgel SuperHZ3000 (4.6 mm I.D. × 15 cm × 1)
   TSKgel SuperHZ2000 (4.6 mm I.D. × 15 cm × 2)
   (All manufactured by Tosoh Corporation)
Column temperature: 40°C
Sample injection volume: 5 µL (a THF solution with a concentration of 0.2% by mass)

### (A) Aliphatic Biscitraconimide Compound

### Synthesis Example 1

First, 60.10 g (1.0 mol) of ethylenediamine, 235.37 g (2.1 mol) of citraconic anhydride, 600 g of toluene, and 257 g of N-methyl-2-pyrrolidone were placed in a 2-L four-necked glass flask equipped with a stirrer, a Dean-Stark apparatus, a cooling condenser, and a thermometer to prepare a reaction liquid. The reaction liquid was stirred at 80°C for 3 hours to synthesize an amic acid. Thereafter, 96.10 g of methanesulfonic acid was added to the reaction liquid. The temperature was increased to 110°C. The mixture was stirred for 16 hours while removing by-product water. The reaction liquid was washed five times with 300 g of ion-exchanged water. Afterward, heptane was used to induce precipitation, followed by filtration to give 65.13 g (yield: 26%) of a target product (A-1, Mn: 148, melting point: 140 °C) as a yellow solid at room temperature.

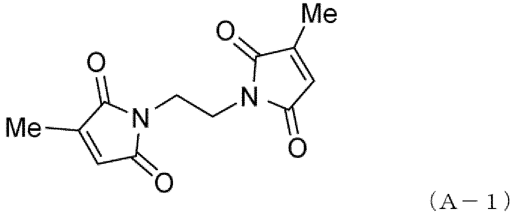

### Synthesis Example 2

First, 88.21 g (1.0 mol) of tetramethylenediamine, 235.37 g (2.1 mol) of citraconic anhydride, 600 g of toluene, and 257 g of N-methyl-2-pyrrolidone were placed in a 2-L four-necked glass flask equipped with a stirrer, a Dean-Stark apparatus, a cooling condenser, and a thermometer to prepare a reaction liquid. The reaction liquid was stirred at 80°C for 3 hours to synthesize an amic acid. Thereafter, 96.10 g of methanesulfonic acid was added to the reaction liquid. The temperature was increased to 110°C. The mixture was stirred for 16 hours while removing by-product water. The reaction liquid was washed five times with 300 g of ion-exchanged water. Afterward, heptane was used to induce precipitation, followed by filtration to give 124.8 g (yield: 45%) of a target product (A-2, Mn: 208, melting point: 120 °C) as a yellow solid at room temperature.

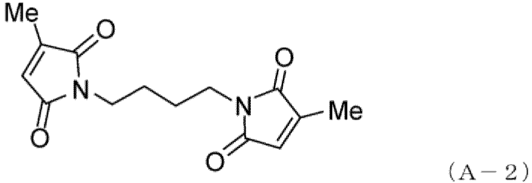

### Synthesis Example 3

First, 116.20 g (1.0 mol) of hexamethylenediamine, 235.37 g (2.1 mol) of citraconic anhydride, 600 g of toluene, and 257 g of N-methyl-2-pyrrolidone were placed in a 2-L four-necked glass flask equipped with a stirrer, a Dean-Stark apparatus, a cooling condenser, and a thermometer to prepare a reaction liquid. The reaction liquid was stirred at 80°C for 3 hours to synthesize an amic acid. Thereafter, 96.10 g of methanesulfonic acid was added to the reaction liquid. The temperature was increased to 110°C. The mixture was stirred for 16 hours while removing by-product water. The reaction liquid was washed five times with 300 g of ion-exchanged water. Afterward, heptane was used to induce precipitation, followed by filtration to give 157.57 g (yield: 52%) of a target product (A-3, Mn: 262, melting point: 110 °C) as a yellow solid at room temperature.

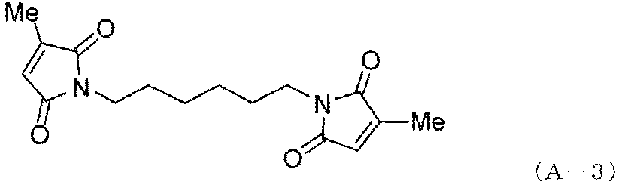

### Synthesis Example 4

First, 158.28 g (1.0 mol) of 1,9-nonanediamine, 235.37 g (2.1 mol) of citraconic anhydride, 600 g of toluene, and 257 g of N-methyl-2-pyrrolidone were placed in a 2-L four-necked glass flask equipped with a stirrer, a Dean-Stark apparatus, a cooling condenser, and a thermometer to prepare a reaction liquid. The reaction liquid was stirred at 80°C for 3 hours to synthesize an amic acid. Thereafter, 96.10 g of methanesulfonic acid was added to the reaction liquid. The temperature was increased to 110°C. The mixture was stirred for 16 hours while removing by-product water. The reaction liquid was washed five times with 300 g of ion-exchanged water. Afterward, heptane was used to induce precipitation, followed by filtration to give 245.97 g (yield: 71%) of a target product (A-4, Mn: 354, melting point: 49 °C) as a yellow solid at room temperature.

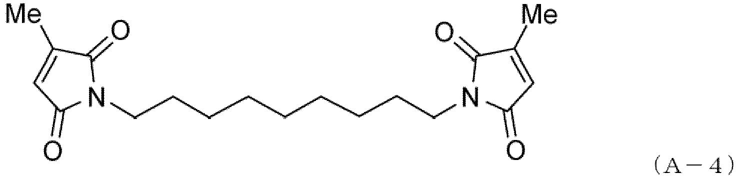

### Synthesis Example 5

First, 200.37 g (1.0 mol) of 1,12-dodecanediamine, 235.37 g (2.1 mol) of citraconic anhydride, 600 g of toluene, and 257 g of N-methyl-2-pyrrolidone were placed in a 2-L four-necked glass flask equipped with a stirrer, a Dean-Stark apparatus, a cooling condenser, and a thermometer to prepare a reaction liquid. The reaction liquid was stirred at 80°C for 3 hours to synthesize an amic acid. Thereafter, 96.10 g of methanesulfonic acid was added to the reaction liquid. The temperature was increased to 110°C. The mixture was stirred for 16 hours while removing by-product water. The reaction liquid was washed five times with 200 g of ion-exchanged water, followed by vacuum stripping at 60°C to give 355.4 g (yield: 91%) of a target product (A-5, Mn: 449) as a brown liquid at room temperature.

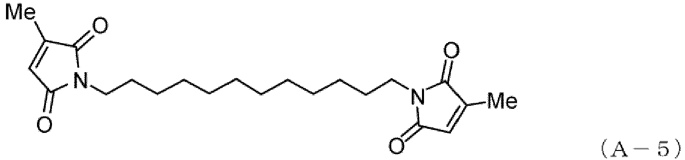

### Synthesis Example 6

First, 71.2 g (0.45 mol) of trimethylhexanediamine (mixture of 2,2,4- and 2,4,4-isomers), 111.0 g (0.99 mol) of citraconic anhydride, and 150 g of toluene were placed in a 2-L four-necked glass flask equipped with a stirrer, a Dean-Stark apparatus, a cooling condenser, and a thermometer to prepare a reaction liquid. The reaction liquid was stirred at 80°C for 3 hours to synthesize an amic acid. Thereafter, 40 g of methanesulfonic acid was added to the reaction liquid. The temperature was increased to 110°C. The mixture was stirred for 16 hours while removing by-product water. The reaction liquid was washed five times with 200 g of ion-exchanged water, followed by vacuum stripping at 60°C to give 149.7 g (yield: 96 %) of a target product (A-6, Mn: 590) as a brown liquid at room temperature.

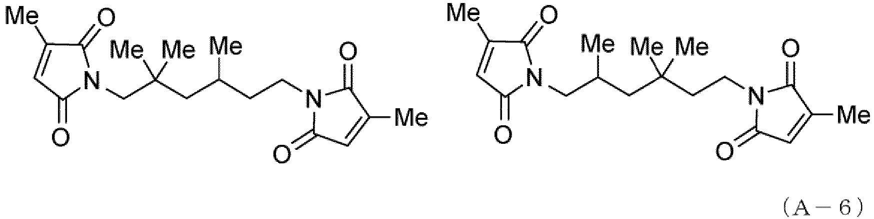

### Comparative Synthesis Example 1

First, 176.67 g (2.0 mol) of 1,4-butanediamine, 411.85 g (4.2 mol) of maleic anhydride, 870 g of toluene, and 870 g of N-methyl-2-pyrrolidone were placed in a 2-L four-necked glass flask equipped with a stirrer, a Dean-Stark apparatus, a cooling condenser, and a thermometer to prepare a reaction liquid. The reaction liquid was stirred at 80°C for 3 hours to synthesize amic acid. Thereafter, 192.25 g of methanesulfonic acid was added to the reaction liquid. The temperature was increased to 110°C. The mixture was stirred for 16 hours while removing by-product water. The reaction liquid was washed five times with 500 g of ion-exchanged water. Afterward, heptane was used to induce precipitation, followed by filtration to give 348.84 g (yield: 70%) of a target product (A'-1, Mn: 205, melting point: 202 °C) as a white solid at room temperature.

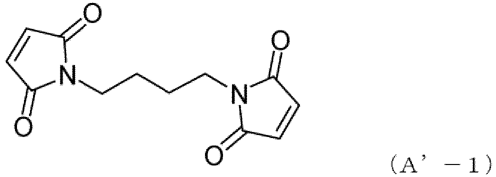

### Comparative Synthesis Example 2

First, 232.42 g (2.0 mol) of hexamethylenediamine, 411.85 g (4.2 mol) of maleic anhydride, 1,200 g of toluene, and 514 g of N-methyl-2-pyrrolidone were placed in a 2-L four-necked glass flask equipped with a stirrer, a Dean-Stark apparatus, a cooling condenser, and a thermometer to prepare a reaction liquid. The reaction liquid was stirred at 80°C for 3 hours to synthesize an amic acid. Thereafter, 192.20 g of methanesulfonic acid was added to the reaction liquid. The temperature was increased to 110°C. The mixture was stirred for 16 hours while removing by-product water. The reaction liquid was washed five times with 500 g of ion-exchanged water. Afterward, heptane was used to induce precipitation, followed by filtration to give 357.92 g (yield: 65%) of a target product (A'-2, Mn: 253, melting point: 143 °C) as a white solid at room temperature.

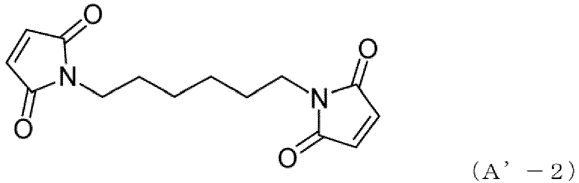

### Comparative Synthesis Example 3

First, 158.35 g (1.0 mol) of trimethylhexanediamine (mixture of 2,2,4- and 2,4,4-isomers), 205.94 g (2.1 mol) of maleic anhydride, 600 g of toluene, and 257 g of N-methyl-2-pyrrolidone were placed in a 2-L four-necked glass flask equipped with a stirrer, a Dean-Stark apparatus, a cooling condenser, and a thermometer to prepare a reaction liquid. The reaction liquid was stirred at 80°C for 3 hours to synthesize an amic acid. Thereafter, 96.10 g of methanesulfonic acid was added to the reaction liquid. The temperature was increased to 110°C. The mixture was stirred for 16 hours while removing by-product water. The reaction liquid was washed five times with 300 g of ion-exchanged water. Afterward, heptane was used to induce precipitation, followed by filtration to give 237.81 g (yield: 75%) of a target product (A'-3, Mn: 318, melting point: 88 °C) as a white solid at room temperature.

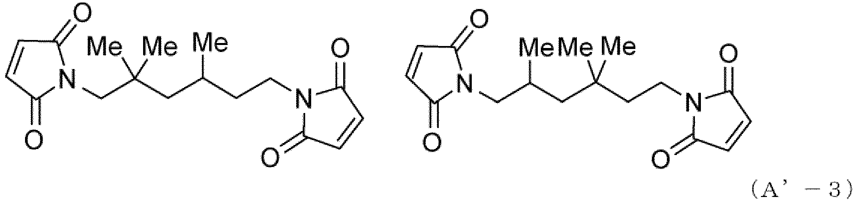

### (B) Epoxy Resin

### (B-1) Dicyclopentadiene-type epoxy resin (trade name: HP-7200: manufactured by DIC Corporation, softening point: 57°C, epoxy equivalent: 259)

### (C) Curing Accelerator

### (C-1) 2-Ethyl-4-methylimidazole (trade name: 2E4MZ, manufactured by Shikoku Kasei Holdings Corporation)

### Working Examples 1 to 9 and Comparative Examples 1 to 3

The above components were mixed in amounts (parts by mass) given in Table 1. The mixture was cast into a mold and cured stepwise at 180°C for 1 hour and then at 230°C for 2 hours to provide a heat-curable resin composition. The resulting resin compositions were evaluated as described below. The results are presented in Table 1. The bismaleimide compound (A'-1) presented in Comparative Example 1 in Table 1 has a melting point near the temperature range (about 200°C) where the curing reaction proceeds. For this reason, when the components were mixed, the melting and curing reaction of the bismaleimide compound (A'-1) proceeded simultaneously, thereby failing to provide a uniform cured product.

In Table 1, each "BCI compound" refers to a biscitraconimide compound, and each "BMI compound" refers to a bismaleimide compound.

### Measurement of Tracking Resistance (CTI)

The above components were mixed in amounts (parts by mass) given in Table 1. The mixture was cast into a mold and cured stepwise at 180°C for 1 hour and then at 230°C for 2 hours to provide a disk-shaped cured product having a thickness of 3 mm and a diameter of 50 mm. The cured product was used to measure the tracking resistance according to the method of JIS C 2134:2021 (IEC 60112). As a tracking resistance voltage, in an evaluation in which five cured products were measured (n = 5), the maximum voltage at which none of the cured products broke even when 50 or more drops of a 0.1% aqueous solution of ammonium chloride fell thereon was measured. The upper limit was 600 V.

### Measurement of Weight Reduction Ratio during Storage at 200°C

The above components were mixed in amounts (parts by mass) given in Table 1. The mixture was cast into a mold and cured stepwise at 180°C for 1 hour and then at 230°C for 2 hours to provide a cured product of a heat-curable resin composition. The cured product was left to stand in a drying oven at 200°C for one week. The weights before and after storage were measured, and the weight reduction ratio during storage at 200°C was calculated.

### Measurement of Flexural Strength

The above components were mixed in amounts (parts by mass) given in Table 1. The mixture was cast into a mold and cured stepwise at 180°C for 1 hour and then at 230°C for 2 hours to provide a test specimen measuring 100 × 10 × 4 mm (thickness). The test specimen was subjected to a three-point flexural test with an AUTOGRAPH manufactured by Shimadzu Corporation in accordance with JIS K 6911:2006, and the flexural strength was calculated.

**Table 1**

| | Working Example 1 | Working Example 2 | Working Example 3 | Working Example 4 | Working Example 5 | Working Example 6 | Working Example 7 | Working Example 8 | Working Example 9 | Comparative Example 1 | Comparative Example 2 | Comparative Example 3 |
|---|---|---|---|---|---|---|---|---|---|---|---|---|
| (A-1) BCI compound | 95 | | | | | | | | | | | |
| (A-2) BCI compound | | 95 | | | | | | | | | | |
| (A-3) BCI compound | | | 95 | | | 75 | 50 | 20 | | | | |
| (A-4) BCI compound | | | | 95 | | | | | | | | |
| (A-5) BCI compound | | | | | | | | | 95 | | | |
| (A-6) BCI compound | | | | | 95 | | | | | | | |
| (A'-1) BMI compound | | | | | | | | | | 95 | | |
| (A'-2) BMI compound | | | | | | | | | | | 95 | |
| (A'-3) BMI compound | | | | | | | | | | | | 95 |
| (B-1) HP-7200 | 5 | 5 | 5 | 5 | 5 | 25 | 50 | 80 | 5 | 5 | 5 | 5 |
| (C-1) 2E4MZ | 2 | 2 | 2 | 2 | 2 | 2 | 2 | 2 | 2 | 2 | 2 | 2 |
| CTI (V) | 600 | 600 | 600 | 600 | 600 | 600 | 600 | 600 | 600 | - | 600 | 600 |
| Weight reduction ratio during storage at 200°C (wt%) | 0.57 | 1.67 | 0.58 | 0.53 | 1.45 | 0.51 | 0.81 | 1.88 | 1.23 | - | 2.73 | 1.93 |
| Flexural strength (M Pa) | 88 | 56 | 88 | 92 | 129 | 93 | 115 | 62 | 135 | - | 38 | 39 |

The results in Table 1 indicated that the cured products of the resin compositions in Working Examples 1 to 9, which contained the aliphatic biscitraconimide compounds, exhibited superior tracking resistance and long-term heat resistance at 200°C compared to the cured products of the resin compositions in Comparative Examples 1 to 3, which contained the aliphatic bismaleimide compounds.

## Claims

1. A heat-curable resin composition, comprising:
(A) an aliphatic biscitraconimide compound represented by formula (1) defined as 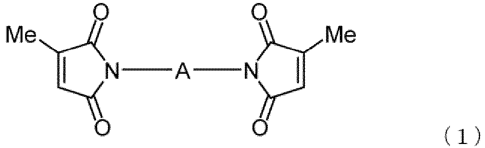 wherein, in the formula (1), A is a divalent aliphatic hydrocarbon group having 2 to 12 carbon atoms; and
(B) an epoxy resin containing two or more epoxy groups in one molecule,
wherein the aliphatic biscitraconimide compound (A) is contained therein in an amount of 20 to 95% by mass based on the total amount of the aliphatic biscitraconimide compound (A) and the epoxy resin (B).

2. The heat-curable resin composition according to claim 1, wherein, in the formula (1), A is a divalent chain aliphatic hydrocarbon group having 2 to 12 carbon atoms.

3. The heat-curable resin composition according to claim 1, further comprising (C) a curing accelerator.

4. The heat-curable resin composition according to claim 3, wherein the curing accelerator (C) contains one or more selected from imidazole-based curing accelerators, organophosphorus-based curing accelerators, and tertiary amine-based curing accelerators.

5. An encapsulant for a semiconductor, comprising the heat-curable resin composition according to any one of claims 1 to 4.

6. The encapsulant for a semiconductor according to claim 5, wherein the semiconductor is a power semiconductor.
